# EUROPÄISCHE PATENTANMELDUNG

(11) **EP 3 713 029 A1**
(43) Veröffentlichungstag der Anmeldung: **23.09.2020**
(21) Anmeldenummer: 19163394.0
(22) Anmeldetag: 18.03.2019
(51) Int. Cl.: H02H 3/16, G01R 31/08, H02H 7/26, H02H 3/04, G01R 31/02, H02J 1/06

(54) **ORTEN EINES ERDSCHLUSSES IN EINEM GLEICHSTROMNETZ MIT MEHREREN LASTZONEN**

(71) Anmelder: Siemens Aktiengesellschaft, 80333 München (DE)
(72) Erfinder: Schierling, Hubert, 91052 Erlangen (DE); Weis, Benno, 91334 Hemhofen (DE)

(57) **Zusammenfassung**

Die Erfindung betrifft ein Verfahren zum Orten eines Erdschlusses in einem Gleichstromnetz (1), dem mehrere Lastzonen (3, 4, 5) zuschaltbar sind. Bei dem Verfahren wird ein Zeitfenster vorgegeben und nach einem Detektieren des Erdschlusses wird der Erdschluss einer Lastzone (3, 4, 5) zugeordnet, die dem Gleichstromnetz (1) innerhalb des Zeitfensters vor dem Detektieren des Erdschlusses zugeschaltet wurde.

## Beschreibung

Die Erfindung betrifft ein Verfahren zum Orten eines Erdschlusses in einem Gleichstromnetz, dem mehrere Lastzonen zuschaltbar sind.

Ein gegenüber einem Erdpotential isoliertes oder über eine hohe Impedanz geerdetes Gleichstromnetz kann bei einem Erdschluss eines Gleichspannungspotentials weiter betrieben werden. Der Erdschluss selbst kann während des Betriebs durch die Messung und Auswertung der Spannungen zwischen den Gleichspannungspotentialen des Gleichstromnetzes und einem Erdpotential leicht detektiert werden. Allerdings ist es schwierig, diejenige an dem Gleichstromnetz angeschlossene Lastzone zu identifizieren, in der der Erdschluss aufgetreten ist. Die Identifizierung derjenigen Lastzone, in der der Erdschluss aufgetreten ist, ist jedoch wichtig, um die fehlerhafte Lastzone abzuschalten und den Erdschluss zu beseitigen. Um die fehlerhafte Lastzone zu identifizieren, könnte beispielsweise an einer Verbindungsstelle jeder Lastzone mit dem Gleichstromnetz, beispielsweise am Eingang eines Schaltschranks, ein so genannter Common-Mode-Strom, das heißt ein Fehlerstrom, der die Summe der Ströme in den beiden Anschlussleitungen der Lastzone zu den Hauptleitungen des Gleichstromnetzes ist, gemessen werden. Wenn einer der Common-Mode-Ströme von Null verschieden ist, weist dies darauf hin, dass der Erdschluss in der zugehörigen Lastzone aufgetreten ist. Die Messungen der Common-Mode-Ströme könnten beispielsweise permanent oder manuell durch Wartungspersonal durchgeführt werden. Jedoch sind derartige Messungen in jedem Fall aufwändig.

Der Erfindung liegt die Aufgabe zugrunde, ein verbessertes Verfahren zum Orten eines Erdschlusses in einem Gleichstromnetz anzugeben, dem mehrere Lastzonen zuschaltbar sind.

Die Aufgabe wird erfindungsgemäß durch ein Verfahren mit den Merkmalen des Anspruchs 1, ein Gleichstromnetz mit den Merkmalen des Anspruchs 14 und ein Gleichstromnetz mit den Merkmalen des Anspruchs 15 gelöst.

Vorteilhafte Ausgestaltungen der Erfindung sind Gegenstand der abhängigen Ansprüche.

Bei dem erfindungsgemäßen Verfahren zum Orten eines Erdschlusses in einem Gleichstromnetz, dem mehrere Lastzonen zuschaltbar sind, wird ein Zeitfenster vorgegeben und nach einem Detektieren des Erdschlusses wird der Erdschluss einer Lastzone zugeordnet, die dem Gleichstromnetz innerhalb des Zeitfensters vor dem Detektieren des Erdschlusses zugeschaltet wurde. Mit anderen Worten wird der Erdschluss einer Lastzone zugeordnet, die dem Gleichstromnetz vor der Erdschlussdetektierung in einem zeitlichen Abstand zu der Erdschlussdetektierung, der kleiner oder gleich dem vorgegebenen Zeitfenster ist, zugeschaltet wurde. Es wird hier und im Folgenden stets angenommen, dass das Gleichstromnetz gegenüber einem Erdpotential isoliert oder über eine hohe Impedanz geerdet ist.

Das erfindungsgemäße Verfahren korreliert also das Detektieren eines Erdschlusses in einem Gleichstromnetz mit dem Zuschalten einer Lastzone zu dem Gleichstromnetz, um die Lastzone zu orten, in der der Erdschluss aufgetreten ist. Dem Verfahren liegt die Überlegung zugrunde, dass, wenn unmittelbar nach dem Zuschalten einer Lastzone ein Erdschluss in dem Gleichstromnetz detektiert wird, es naheliegt, dass bereits vor dem Zuschalten in dieser Lastzone ein Erdschluss vorlag. Um diese Lastzone zu bestimmen, sieht das Verfahren die Vorgabe eines Zeitfensters vor, um das Detektieren eines Erdschlusses mit dem Zuschalten einer Lastzone zu korrelieren. Ein Erdschluss wird einer Lastzone zugeordnet, die dem Gleichstromnetz innerhalb des vorgegebenen Zeitfensters vor dem Detektieren des Erdschlusses zugeschaltet wurde. Wenn dem Gleichstromnetz innerhalb des vorgegebenen Zeitfensters vor dem Detektieren des Erdschlusses keine Lastzone zugeschaltet wurde, wird der Erdschluss keiner Lastzone zugeordnet beziehungsweise muss auf andere Weise geortet werden. Als Zeitfenster wird beispielsweise eine Zeitdauer von einigen Millisekunden vorgegeben. Das Verfahren ist sehr einfach und aufwandsarm und somit auch kostengünstig realisierbar, da nur die Zeitpunkte des Detektierens eines Erdschlusses und des Zuschaltens der Lastzonen ausgewertet werden müssen. Zum Detektieren des Erdschlusses brauchen dabei die Spannungen zwischen einem Erdpotential und Gleichspannungspotentialen des Gleichstromnetzes nur an einer einzigen Stelle des Gleichstromnetzes gemessen werden.

Bei einer Ausgestaltung des Verfahrens wird, wenn dem Gleichstromnetz innerhalb des Zeitfensters vor dem Detektieren des Erdschlusses mehrere Lastzonen zugeschaltet wurden, der Erdschluss derjenigen dieser Lastzonen zugeordnet, die dem Gleichstromnetz innerhalb des Zeitfensters am spätesten zugeschaltet wurde. Diese Ausgestaltung des Verfahrens ermöglicht eine Ortung des Erdschlusses auch in dem Fall, dass dem Gleichstromnetz zwei oder mehr Lastzonen kurz nacheinander innerhalb des vorgegebenen Zeitfensters vor dem Detektieren eines Erdschlusses zugeschaltet wurden.

Bei einer weiteren Ausgestaltung des Verfahrens wird die Lastzone, der der Erdschluss zugeordnet wird, von dem Gleichstromnetz getrennt. Ferner kann vorgesehen sein, dass nach dem Trennen der Lastzone von dem Gleichstromnetz geprüft wird, ob weiterhin ein Erdschluss in dem Gleichstromnetz vorliegt, und dass die Zuordnung des Erdschlusses zu der Lastzone aufgehoben wird und die Lastzone dem Gleichstromnetz wieder zugeschaltet wird, wenn nach dem Trennen der Lastzone von dem Gleichstromnetz weiterhin ein Erdschluss vorliegt. Diese Ausgestaltung des Verfahrens ermöglicht insbesondere eine Überprüfung einer vorgenommenen Zuordnung eines Erdschlusses zu einer Lastzone. Wenn nämlich nach dem Trennen dieser Lastzone von dem Gleichstromnetz der Erdschluss in dem Gleichstromnetz immer noch vorliegt, liegt es nahe, dass der Erdschluss nicht in dieser Lastzone sondern an einer anderen Stelle des Gleichstromnetzes liegt, so dass die Zuordnung des Erdschlusses zu der Lastzone wahrscheinlich falsch ist.

Bei einer weiteren Ausgestaltung des Verfahrens werden von einer Auswerteeinheit ein Detektionszeitpunkt des Detektierens des Erdschlusses, das Zeitfenster sowie für jedes Zuschalten einer Lastzone ein Zuschaltzeitpunkt des Zuschaltens und eine Zuschaltzuordnung des Zuschaltzeitpunkts zu der zugeschalteten Lastzone gespeichert und anhand dieser gespeicherten Daten wird der Erdschluss von der Auswerteeinheit einer Lastzone zugeordnet. Dabei kann die Auswerteeinheit separat ausgeführt oder eine Steuereinheit, von der das Zuschalten von Lastzonen gesteuert wird, oder eine Erdschlussüberwachungseinheit, die zum Detektieren eines Erdschlusses eingerichtet ist, sein. Wenn die Auswerteeinheit separat ausgeführt oder die Erdschlussüberwachungseinheit ist, wird der Auswerteeinheit beispielsweise jeder Zuschaltzeitpunkt und dessen Zuschaltzuordnung von einer Steuereinheit, von der das Zuschalten von Lastzonen gesteuert wird, gemeldet. Wenn die Auswerteeinheit separat ausgeführt oder die Steuereinheit ist, wird der Erdschluss beispielsweise von einer Erdschlussüberwachungseinheit detektiert und der Auswerteeinheit gemeldet.

Bei den vorgenannten Ausgestaltungen des Verfahrens werden die Zeitpunkte des Detektierens eines Erdschlusses und des Zuschaltens von Lastzonen also von einer Auswerteeinheit gespeichert und ausgewertet. Dabei kann die Auswerteeinheit vorteilhaft als eine Steuereinheit, von der das Zuschalten von Lastzonen gesteuert wird, oder als eine Erdschlussüberwachungseinheit, die zum Detektieren eines Erdschlusses eingerichtet ist, ausgeführt sein, insbesondere wenn derartige Einheiten ohnehin in dem Gleichstromnetz vorgesehen sind.

Bei einer alternativen Ausgestaltung des Verfahrens weist das Gleichstromnetz für jede Lastzone eine der Lastzone zugeordnete Zuschalteinheit auf, durch die die Lastzone dem Gleichstromnetz zuschaltbar ist, und von jeder Zuschalteinheit wird das Zeitfenster gespeichert und für jedes Zuschalten der Lastzone, der die Zuschalteinheit zugeordnet ist, ermittelt, ob das Zuschalten innerhalb des Zeitfensters vor dem Detektieren des Erdschlusses erfolgte. Der Erdschluss wird beispielsweise von einer Erdschlussüberwachungseinheit detektiert und jeder Zuschalteinheit gemeldet, oder jede Zuschalteinheit ist dazu eingerichtet, einen Erdschluss selbständig zu detektieren.

Die vorgenannten Ausgestaltungen des Verfahrens sehen also statt einer Auswerteeinheit, die die Zeitpunkte des Zuschaltens aller Lastzonen auswertet, vor, dass diese Zeitpunkte für jede Lastzone separat von einer Zuschalteinheit der jeweiligen Lastzone ausgewertet werden. Zusätzlich kann vorgesehen sein, dass die Zuschalteinheiten auch einen Erdschluss in dem Gleichstromnetz selbständig detektieren.

Bei einer weiteren Ausgestaltung des Verfahrens werden nach dem Detektieren eines Erdschlusses zunächst alle Lastzonen von dem Gleichstromnetz getrennt. Danach werden dem Gleichstromnetz Lastzonen nacheinander zu voneinander verschiedenen Zuschaltzeitpunkten jeweils für eine Zuschaltdauer, die größer als das Zeitfenster ist und nicht mit der Zuschaltdauer einer anderen Lastzone überlappt, zugeschaltet und für jedes Zuschalten einer Lastzone wird geprüft, ob innerhalb des Zeitfensters nach dem Zuschalten ein Erdschluss auftritt. Diese Ausgestaltung des Verfahrens ermöglicht eine systematische Suche derjenigen Lastzone, in der ein Erdschluss aufgetreten ist.

Ein erstes erfindungsgemäßes Gleichstromnetz, dem mehrere Lastzonen zuschaltbar sind, weist entsprechend einer oben genannten Ausgestaltung des erfindungsgemäßen Verfahrens eine Auswerteeinheit auf, die dazu eingerichtet ist, einen Detektionszeitpunkt des Detektierens eines Erdschlusses, ein vorgebbares Zeitfenster sowie für jedes Zuschalten einer Lastzone einen Zuschaltzeitpunkt des Zuschaltens und eine Zuschaltzuordnung des Zuschaltzeitpunkts zu der zugeschalteten Lastzone zu speichern und den Erdschluss einer Lastzone zuzuordnen, die dem Gleichstromnetz innerhalb des Zeitfensters vor dem Detektieren des Erdschlusses zugeschaltet wurde.

Ein zweites erfindungsgemäßes Gleichstromnetz, dem mehrere Lastzonen zuschaltbar sind, weist entsprechend einer ebenfalls oben genannten Ausgestaltung des erfindungsgemäßen Verfahrens für jede Lastzone eine der Lastzone zugeordnete Zuschalteinheit auf, durch die die Lastzone dem Gleichstromnetz zuschaltbar ist und die dazu eingerichtet ist, ein vorgebbares Zeitfenster zu speichern und für jedes Zuschalten der Lastzone, der sie zugeordnet ist, zu ermitteln, ob das Zuschalten innerhalb des Zeitfensters vor dem Detektieren des Erdschlusses erfolgte.

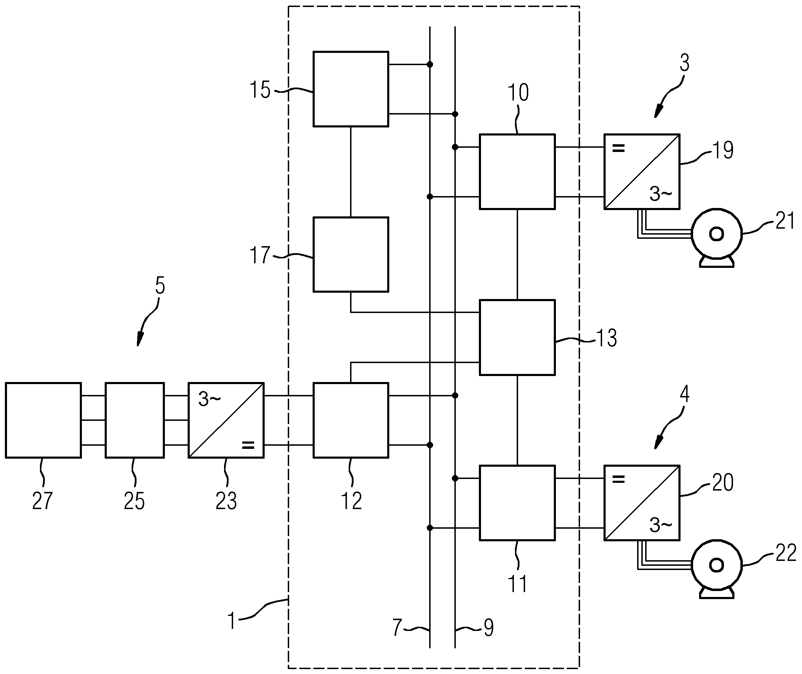

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit der Zeichnung näher erläutert werden.

Dabei zeigt die einzige Figur schematisch ein Gleichstromnetz 1, dem mehrere Lastzonen 3, 4, 5 zuschaltbar sind. Das Gleichstromnetz 1 ist gegenüber einem Erdpotential isoliert oder über eine hohe Impedanz geerdet.

Das Gleichstromnetz 1 weist zwei elektrische Hauptleitungen 7, 9, mehrere Zuschalteinheiten 10 bis 12, eine Steuereinheit 13, eine Erdschlussüberwachungseinheit 15 und eine Auswerteeinheit 17 auf.

In der Figur sind beispielhaft drei Lastzonen 3, 4, 5 dargestellt. Eine erste Lastzone 3 und eine zweite Lastzone 4 weisen jeweils einen Stromrichter 19, 20 und eine elektrische Maschine 21, 22 auf. Eine dritte Lastzone 5 weist einen Stromrichter 23, eine Schalt- und Schutzeinheit 25 für Wechselstrom und ein Wechselstromnetz 27 auf, wobei die Schalt- und Schutzeinheit 25 zwischen das Wechselstromnetz 27 und den Stromrichter 23 geschaltet ist. Jeder Stromrichter 19, 20, 23 ist mit einer Zuschalteinheit 10, 11, 12 verbunden.

Eine erste Hauptleitung 7 liegt auf einem ersten Gleichspannungspotential des Gleichstromnetzes 1. Die zweite Hauptleitung 9 liegt auf einem zweiten Gleichspannungspotential des Gleichstromnetzes 1.

Jede Zuschalteinheit 10, 11, 12 ist einer Lastzone 3, 4, 5 zugeordnet, die dem Gleichstromnetz 1 durch die Zuschaltschalteinheit 10, 11, 12 zuschaltbar ist.

Von der Steuereinheit 13 wird das Zuschalten der Lastzonen 3, 4, 5 gesteuert. Dazu sind die Zuschalteinheiten 10, 11, 12 von der Steuereinheit 13 ansteuerbar. Ferner ist die Steuereinheit 13 dazu ausgebildet, der Auswerteeinheit 17 für jedes Zuschalten einer Lastzone 3, 4, 5 einen Zuschaltzeitpunkt des Zuschaltens und eine Zuschaltzuordnung des Zuschaltzeitpunkts zu der zugeschalteten Lastzone 3, 4, 5 zu melden.

Die Erdschlussüberwachungseinheit 15 ist dazu eingerichtet, einen Erdschluss eines Gleichspannungspotentials des Gleichstromnetzes 1 zu detektieren. Dazu ist die Erdschlussüberwachungseinheit 15 mit jeder Hauptleitung 7, 9 verbunden und dazu eingerichtet, die Spannungen zwischen einem Erdpotential und den Gleichspannungspotentialen, auf denen die Hauptleitungen 7, 9 liegen, zu messen. Ferner ist die Erdschlussüberwachungseinheit 15 dazu eingerichtet, der Auswerteeinheit 17 einen detektierten Erdschluss zu melden.

Die Auswerteeinheit 17 ist dazu eingerichtet, den Detektionszeitpunkt des Detektierens eines Erdschlusses, ein vorgebbares Zeitfenster sowie die ihr von der Steuereinheit 13 gemeldeten Zuschaltzeitpunkte und Zuschaltzuordnungen zu speichern und anhand dieser gespeicherten Daten den Erdschluss einer Lastzone zuzuordnen. Der Erdschluss wird dabei einer Lastzone 3, 4, 5 zugeordnet, die dem Gleichstromnetz 1 innerhalb des Zeitfensters vor dem Detektieren des Erdschlusses zugeschaltet wurde. Wenn dem Gleichstromnetz 1 innerhalb des Zeitfensters vor dem Detektieren des Erdschlusses keine Lastzone 3, 4, 5 zugeschaltet wurde, wird der Erdschluss von der Auswerteeinheit 17 keiner Lastzone 3, 4, 5 zugeordnet. Wenn dem Gleichstromnetz 1 innerhalb des Zeitfensters vor dem Detektieren des Erdschlusses mehrere Lastzonen 3, 4, 5 zugeschaltet wurden, wird der Erdschluss von der Auswerteeinheit 17 derjenigen dieser Lastzonen 3, 4, 5 zugeordnet, die dem Gleichstromnetz 1 innerhalb des Zeitfensters am spätesten zugeschaltet wurde. Als Zeitfenster wird beispielsweise eine Zeitdauer von einigen Millisekunden vorgegeben und von der Auswerteeinheit 17 gespeichert.

Die anhand der Figur beschriebenen Ausführungsbeispiele eines erfindungsgemäßen Gleichstromnetzes 1 und des erfindungsgemäßen Verfahrens können auf verschiedene Weisen zu weiteren Ausführungsbeispielen abgewandelt werden.

Beispielsweise kann vorgesehen sein, dass der Auswerteeinheit 17 die Zuschaltzeitpunkte und Zuschaltzuordnungen der Lastzonen 3, 4, 5 nicht von der Steuereinheit 13, sondern von den Zuschalteinheiten 10, 11, 12 gemeldet werden.

Ferner kann beispielsweise vorgesehen sein, dass die Lastzone 3, 4, 5, der der Erdschluss zugeordnet wird, durch die ihr zugeordnete Zuschalteinheit 10, 11, 12 von dem Gleichstromnetz 1 getrennt wird, und dass nach dem Trennen der Lastzone 3, 4, 5 von dem Gleichstromnetz 1 geprüft wird, ob weiterhin ein Erdschluss vorliegt. Wenn nach dem Trennen der Lastzone 3, 4, 5 von dem Gleichstromnetz 1 weiterhin ein Erdschluss vorliegt, wird die Zuordnung des Erdschlusses zu der Lastzone 3, 4, 5 aufgehoben und die Lastzone 3, 4, 5 wird dem Gleichstromnetz wieder zugeschaltet.

Des Weiteren kann bei einem Erdschluss vorgesehen sein, dass nach dem Erdschluss zunächst alle Lastzonen 3, 4, 5 durch ihre Zuschalteinheiten 10, 11, 12 von dem Gleichstromnetz 1 getrennt werden. Danach wird systematisch nach der fehlerhaften Lastzone 3, 4, 5 gesucht, indem dem Gleichstromnetz 1 Lastzonen 3, 4, 5 nacheinander zu voneinander verschiedenen Zuschaltzeitpunkten jeweils für eine Zuschaltdauer, die größer als das Zeitfenster ist und nicht mit der Zuschaltdauer einer anderen Lastzone 3, 4, 5 überlappt, zugeschaltet werden und für jedes Zuschalten einer Lastzone 3, 4, 5 geprüft wird, ob innerhalb des Zeitfensters nach dem Zuschalten ein Erdschluss auftritt.

Des Weiteren kann statt einer separaten Auswerteeinheit 17 vorgesehen sein, dass die Steuereinheit 13 oder die Erdschlussüberwachungseinheit 15 als die Auswerteeinheit 17 ausgebildet ist. Im Fall, dass die Steuereinheit 13 als die Auswerteeinheit 17 ausgebildet ist, wird der Steuereinheit 13 ein Erdschluss von der Erdschlussüberwachungseinheit 15 gemeldet und die Steuereinheit 13 ist dazu eingerichtet, bei einem Erdschluss zu prüfen, ob dem Gleichstromnetz 1 innerhalb des Zeitfensters vor dem Detektieren des Erdschlusses eine Lastzone 3, 4, 5 zugeschaltet wurde. Im Fall, dass die Erdschlussüberwachungseinheit 15 als die Auswerteeinheit 17 ausgebildet ist, werden der Erdschlussüberwachungseinheit 15 die Zuschaltzeitpunkte und Zuschaltzuordnungen der Lastzonen 3, 4, 5 von der Steuereinheit 13 oder den Zuschalteinheiten 10, 11, 12 gemeldet und die Erdschlussüberwachungseinheit 15 ist dazu eingerichtet, bei einem Erdschluss zu prüfen, ob dem Gleichstromnetz 1 innerhalb des Zeitfensters vor dem Detektieren des Erdschlusses eine Lastzone 3, 4, 5 zugeschaltet wurde.

Ferner kann statt einer Auswerteeinheit 17 vorgesehen sein, dass bei einem Erdschluss von jeder Zuschalteinheit 10, 11, 12 selbständig ermittelt wird, ob ein Zuschalten der Lastzone 3, 4, 5, der die Zuschalteinheit 10, 11, 12 zugeordnet ist, innerhalb des Zeitfensters vor dem Detektieren des Erdschlusses erfolgte. Dabei ist jede Zuschalteinheit 10, 11, 12 dazu eingerichtet, das Zeitfenster und die Zuschaltzeitpunkte der Lastzone 3, 4, 5, der die Zuschalteinheit 10, 11, 12 zugeordnet ist, zu speichern und im Falle eines Erdschlusses zu prüfen, ob ein Zuschaltzeitpunkt innerhalb des Zeitfensters vor dem Detektieren des Erdschlusses liegt. Der Erdschluss wird entweder von der Erdschlussüberwachungseinheit 15 allen Zuschalteinheiten 10, 11, 12 gemeldet oder jede Zuschalteinheit 10, 11, 12 ist dazu ausgebildet, einen Erdschluss selbständig zu detektieren.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Orten eines Erdschlusses in einem Gleichstromnetz (1), dem mehrere Lastzonen (3, 4, 5) zuschaltbar sind, wobei
- ein Zeitfenster vorgegeben wird
- und nach einem Detektieren des Erdschlusses der Erdschluss einer Lastzone (3, 4, 5) zugeordnet wird, die dem Gleichstromnetz (1) innerhalb des Zeitfensters vor dem Detektieren des Erdschlusses zugeschaltet wurde.

2. Verfahren nach Anspruch 1, wobei, wenn dem Gleichstromnetz (1) innerhalb des Zeitfensters vor dem Detektieren des Erdschlusses mehrere Lastzonen (3, 4, 5) zugeschaltet wurden, der Erdschluss derjenigen dieser Lastzonen (3, 4, 5) zugeordnet wird, die dem Gleichstromnetz (1) innerhalb des Zeitfensters am spätesten zugeschaltet wurde.

3. Verfahren nach Anspruch 1 oder 2, wobei die Lastzone (3, 4, 5), der der Erdschluss zugeordnet wird, von dem Gleichstromnetz (1) getrennt wird.

4. Verfahren nach Anspruch 3, wobei nach dem Trennen der Lastzone (3, 4, 5) von dem Gleichstromnetz (1) geprüft wird, ob weiterhin ein Erdschluss vorliegt, und wenn nach dem Trennen der Lastzone (3, 4, 5) von dem Gleichstromnetz (1) weiterhin ein Erdschluss in dem Gleichstromnetz (1) vorliegt, die Zuordnung des Erdschlusses zu der Lastzone (3, 4, 5) aufgehoben wird und die Lastzone (3, 4, 5) dem Gleichstromnetz (1) wieder zugeschaltet wird.

5. Verfahren nach einem der vorhergehenden Ansprüche, wobei von einer Auswerteeinheit (17) ein Detektionszeitpunkt des Detektierens des Erdschlusses, das Zeitfenster sowie für jedes Zuschalten einer Lastzone (3, 4, 5) ein Zuschaltzeitpunkt des Zuschaltens und eine Zuschaltzuordnung des Zuschaltzeitpunkts zu der zugeschalteten Lastzone (3, 4, 5) gespeichert werden und anhand dieser gespeicherten Daten der Erdschluss einer Lastzone (3, 4, 5) zugeordnet wird.

6. Verfahren nach Anspruch 5, wobei die Auswerteeinheit (17) eine Steuereinheit (13) ist, von der das Zuschalten von Lastzonen (3, 4, 5) gesteuert wird.

7. Verfahren nach Anspruch 5, wobei die Auswerteeinheit (17) eine Erdschlussüberwachungseinheit (15) ist, die zum Detektieren eines Erdschlusses eingerichtet ist.

8. Verfahren nach Anspruch 5 oder 7, wobei der Auswerteeinheit (17) jeder Zuschaltzeitpunkt und dessen Zuschaltzuordnung von einer Steuereinheit (13), von der das Zuschalten von Lastzonen (3, 4, 5) gesteuert wird, gemeldet wird.

9. Verfahren nach Anspruch 5 oder 6, wobei der Erdschluss von einer Erdschlussüberwachungseinheit (15) detektiert und der Auswerteeinheit (17) gemeldet wird.

10. Verfahren nach einem der Ansprüche 1 bis 4, wobei das Gleichstromnetz (1) für jede Lastzone (3, 4, 5) eine der Lastzone (3, 4, 5) zugeordnete Zuschalteinheit (10, 11, 12) aufweist, durch die die Lastzone (3, 4, 5) dem Gleichstromnetz (1) zuschaltbar ist, und von jeder Zuschalteinheit (10, 11, 12) das Zeitfenster gespeichert und für jedes Zuschalten der Lastzone (3, 4, 5), der die Zuschalteinheit (10, 11, 12) zugeordnet ist, ermittelt wird, ob das Zuschalten innerhalb des Zeitfensters vor dem Detektieren des Erdschlusses erfolgte.

11. Verfahren nach Anspruch 10, wobei der Erdschluss von einer Erdschlussüberwachungseinheit (15) detektiert und jeder Zuschalteinheit (10, 11, 12) gemeldet wird.

12. Verfahren nach Anspruch 10, wobei jede Zuschaltschalteinheit (10, 11, 12) dazu eingerichtet ist, einen Erdschluss zu detektieren.

13. Verfahren nach einem der vorhergehenden Ansprüche, wobei nach dem Detektieren eines Erdschlusses zunächst alle Lastzonen (3, 4, 5) von dem Gleichstromnetz (1) getrennt werden und dem Gleichstromnetz (1) danach Lastzonen (3, 4, 5) zu voneinander verschiedenen Zuschaltzeitpunkten jeweils für eine Zuschaltdauer, die größer als das Zeitfenster ist und nicht mit der Zuschaltdauer einer anderen Lastzone (3, 4, 5) überlappt, zugeschaltet werden und für jedes Zuschalten einer Lastzone (3, 4, 5) geprüft wird, ob innerhalb des Zeitfensters nach dem Zuschalten ein Erdschluss auftritt.

14. Gleichstromnetz (1), dem mehrere Lastzonen (3, 4, 5) zuschaltbar sind und das eine Auswerteeinheit (17) aufweist, die dazu eingerichtet ist, einen Detektionszeitpunkt des Detektierens eines Erdschlusses, ein vorgebbares Zeitfenster sowie für jedes Zuschalten einer Lastzone (3, 4, 5) einen Zuschaltzeitpunkt des Zuschaltens und eine Zuschaltzuordnung des Zuschaltzeitpunkts zu der zugeschalteten Lastzone (3, 4, 5) zu speichern und den Erdschluss einer Lastzone (3, 4, 5) zuzuordnen, die dem Gleichstromnetz (1) innerhalb des Zeitfensters vor dem Detektieren des Erdschlusses zugeschaltet wurde.

15. Gleichstromnetz (1), dem mehrere Lastzonen (3, 4, 5) zuschaltbar sind und das für jede Lastzone (3, 4, 5) eine der Lastzone (3, 4, 5) zugeordnete Zuschalteinheit (10, 11, 12) aufweist, durch die die Lastzone (3, 4, 5) dem Gleichstromnetz (1) zuschaltbar ist und die dazu eingerichtet ist, ein vorgebbares Zeitfenster zu speichern und für jedes Zuschalten der Lastzone (3, 4, 5), der sie zugeordnet ist, zu ermitteln, ob das Zuschalten innerhalb des Zeitfensters vor dem Detektieren des Erdschlusses erfolgte.
